# EUROPEAN PATENT APPLICATION

(11) **EP 0 633 663 A1**
(43) Date of publication of application: **11.01.1995**
(21) Application number: 94304383.6
(22) Date of filing: 16.06.1994
(51) Int. Cl.: H03K 17/968, B23K 3/047

(54) **Switching assembly for hand tools**

(30) Priority: 02.07.1993 DE 9309880 U
(71) Applicant: Cooper Industries Inc., Houston Texas 77002 (US)
(72) Inventor: Kurpiela, Gerhard, D-7129 Brackenheim (DE); Munz, Volker, D-7125 Kirscheim (DE)
(74) Representative: Jackson, Peter Arthur

(57) **Abstract**

A switching assembly for a hand tool, the assembly comprising a tool holding fixture (1) and a power supply device (3), characterized in that the tool holding fixture (1) is connected to the power supply device (3) via an optical fibre (2); and there are means (3) for switching the power supply device in response to changes in the light transmitted along the fibre.

## Description

The present invention relates to a switching assembly for hand tools, comprising a tool holding fixture connected with a power source, wherein the power source is switched depending upon whether a manual device or hand tool has been deposited in the tool holding fixture. The invention relates, in particular, to a switching arrangement for a manual soldering device, wherein the manual soldering device and a solder vapour suction arrangement, possibly connected therewith, or other work units are turned off automatically when the manual soldering device is deposited in the tool holding fixture.

With the switching devices of this type which are known so far, an electrical switch is provided in the tool holding fixture and, when the hand tool is deposited, it is operated by the pressure of the device housing. The switch controls the power supply of the deposited manual device so that the power supply is interrupted when the manual device is located in the tool holding fixture and that the power supply is established when the tool holding fixture is empty. The switch integrated in the tool holding fixture is subsequently electrically connected to the power source of the device via appropriate lines.

The disadvantage of this state of the art is that the tool holding fixture must meet the increased safety regulations for electrically connected devices, since the integrated switch is under constant electrical voltage during operation of the device. In the same way, the switch itself must meet the necessary requirements in such a way that, on the one hand, the safe turning off is assured when the manual device is deposited and, on the other hand, a disturbance-free operation of the manual device is possible upon removal from the fixture. For example, a loose connection in the integrated switch would not only render the switching devices known so far unusable, but could endanger the operator when the manual device inadvertently continues to run inside the tool holding fixture.

The object of the present invention lies in overcoming these disadvantages of the state of the art, and in particular to provide a switching device for a hand tool which assures safe control of a power supply, depending on whether the tool holding fixture is free or occupied, while the tool holding fixture itself has no elements whatsoever which carry an electrical voltage.

According to the present invention a switching device for a hand tool comprises a tool holding fixture and a power supply device, characterized in that the tool holding fixture is connected to the power supply device via an optical fibre; and there are means for switching the power supply device in response to changes in the light transmitted along the fibre.

The switching assembly of the invention has the advantage that the tool holding fixture itself is not electrically connected and no longer requires integrated electrical switches in the tool holding fixture. Rather, the electronic elements are provided in a separate electronic circuit which is connected to the tool holding fixture by means of an electrically nonconductive optical fibre. In this way, the increased safety regulations for electrical devices do not apply to the tool holding fixture.

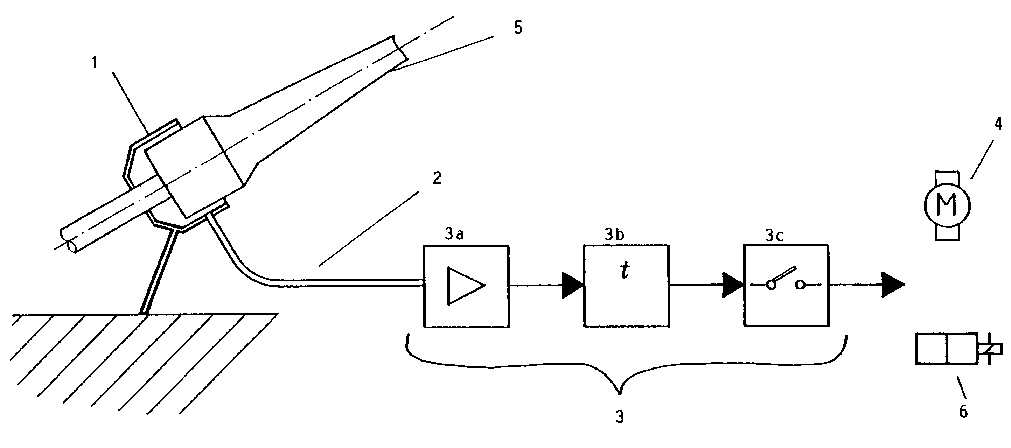

A preferred embodiment of the invention is described in connection with the accompanying drawing.

As can be seen from the drawing, the switching device shown comprises a tool holding fixture (1), which may be of conventional construction. This tool holding fixture is connected via an optical fibre (2) to a plug-in charger (3) (i.e. a recharging point for the battery of a battery-energised, cordless hand tool). The plug-in charger (3) comprises a circuit (3a), a timing element (3b) and a switching element (3c). The plug-in charger is in turn connected to a power source (not shown) and with a pump arrangement (4). In the tool holding fixture, a manual soldering tool (5) is deposited. The manual soldering tool is fed by the power source and, furthermore, is connected to the pump device serving for drawing off the soldering vapours.

The operating principle of the switching assembly of the invention is based on the fact that by depositing and removing the hand tool, the optical fibre end is covered or exposed at the tool holding fixture, whereby the intensity of the light, transferred from the tool holding fixture via the optical fibre to the plug-in charger, is either reduced or increased accordingly. These variations of the light intensity are converted by a photoelement inside the circuit (3a) into a corresponding electrical signal which is evaluated by the circuit (3a). In one embodiment, the logic of the circuit (3a) is conceived in such a way that an "OFF" signal is emitted when the light intensity drops below a certain lower threshold value or to zero due to being covered, and that an "ON" signal is emitted when the light intensity exceeds a certain upper threshold value. The output signal "ON" or "OFF" is fed to the time element (3b) which feeds this signal to the switching element (3c) after a predetermined delay time (t). In accordance with the logical value ("ON"/"OFF") of the given signal, the switching element turns on or off the power supply for the devices connected to the plug-in charger. In the arrangement shown, the optional time element (3b) has the purpose of allowing the pump arrangement (4) to continue to run for the predetermined delay time when the manual soldering device has already been deposited, so that the soldering vapours still being produced can be drawn off by means of the pump arrangement.

Accordingly, an optical fibre is introduced inside the tool holding fixture with its operating end in such a way that the tool inside the holder covers the light intrusion into the fibre. When the tool is removed, the light of the surroundings suffices, when guided through the fibre, to trigger a subsequent electronic circuit which in turn activates the switching operation of the connected devices. This may include, for example, turning on a pump arrangement (4) for producing the evacuation flow for the removal of the soldering fumes at the soldering site or turning on a solenoid operated spool valve (6) for operating a compressed air converter for producing the vacuum. After the tool has been deposited again, depending on the intended purpose, an electronic switching element, such as a time element (3b), can maintain the switching state for a certain, predeterminable amount of time.

As is made clear in the example, the tool holding fixture has no electrical connection to the power source or the plug-in charger and is free of energized parts. Owing to this electrical decoupling of the invented tool holding fixture from the electrical components of the switching arrangement, connected via only one electrically insulated optical fibre with the tool holding fixture, the required safety measures, which otherwise must be taken with electrical devices, are eased considerably. Furthermore, the production of the tool holding fixture is simplified because no electrical switch has to be provided there.

Within the framework of the invention, other embodiments are also possible, such as a switching arrangement for any type of hand tool without a pump arrangement or a plug-in charger without a time element.

## Claims

1. A switching assembly for a hand tool, the assembly comprising a tool holding fixture (1) and a power supply device (3), characterized in that the tool holding fixture (1) is connected to the power supply device (3) via an optical fibre (2); and there are means (3) for switching the power supply device in response to changes in the light transmitted along the fibre.

2. An assembly according to claim 1, wherein the power supply arrangement (3) controls the power supply of the hand tool (5) for which the tool holding fixture is provided.

3. An assembly according to claim 1 or claim 2, wherein the tool holding fixture (1) is arranged to cooperate with the hand tool (5) in such a way, that the intensity of the light conducted from the tool holding fixture via the optical fibre (2) towards the power supply device (3), is reduced when the hand tool (5) is deposited in the tool holding fixture (1).

4. A assembly according to claim 3, wherein one end of the optical fibre, extending into the tool holding fixture, is covered by the hand tool when placed into the tool holding fixture (1).

5. An assembly according to any one of the preceding claims, wherein the power supply device (3) comprises a plug-in charger having a circuit (3a) and a switching element (3c), which are electrically connected to a power source.

6. An assembly according to claim 5, wherein the circuit (3a) contains a photoelement which is situated at the other end of the optical fibre (2), so that the circuit (3a) emits an "ON" signal when the light intensity from the optical fibre (2) drops below a lower threshold value and emits an "OFF" signal when the light intensity exceeds an upper threshold value.

7. An assembly according to claim 6, wherein the output signal of the circuit (3a) is applied to the switching element (3c), which controls a connected power source in accordance with the signal.

8. An assembly according to claim 7, wherein the circuit (3a) and the switching element (3c) are connected via a time element (3b) which directs the output signal from the circuit (3a) to the switching element (3c) only after a certain delay time (t).

9. An assembly according to any one of the preceding claims, wherein the power supply device (3), controls at least one additional device in addition to the hand tool (5), depending on the light intensity inside the optical fibre (2).

10. An assembly according to claim 9, wherein the additional device(s) includes a pump (4) and/or a magnetically operated valve (6).
